Europäisches Patentamt

European Patent Office

Office européen des brevets

(11) Veröffentlichungsnummer: **0 549 946 A2**

# (12) EUROPÄISCHE PATENTANMELDUNG

(21) Anmeldenummer: **92121279.1**

(22) Anmeldetag: **15.12.92**

(51) Int. Cl.5: **G03F 7/004**, C08F 257/02, C08F 283/10, H05K 3/34

(30) Priorität: **21.12.91 DE 4142735**

(43) Veröffentlichungstag der Anmeldung: **07.07.93 Patentblatt 93/27**

(84) Benannte Vertragsstaaten: **CH DE FR GB LI**

(71) Anmelder: **HOECHST AKTIENGESELLSCHAFT Postfach 80 03 20 W-6230 Frankfurt am Main 80(DE)**

(72) Erfinder: **Schütze, Gerald, Dr. Ubierstrasse 13 W-6238 Hofheim/Ts.(DE)** Erfinder: **Decker, Rudolf, DI Wormser Strasse 10 W-6501 Bodenheim(DE)** Erfinder: **Lingnau, Jürgen, Dr. Karolingerstrasse 10 W-6500 Mainz-Laubenheim(DE)**

(54) **Durch Strahlung polymerisierbares Gemisch und Verfahren zur Herstellung einer Lötstoppmaske.**

(57) Es wird ein durch Strahlung polymerisierbares Gemisch beschrieben, das

a) eine Verbindung mit mindestens einer radikalisch polymerisierbaren Gruppe,

b) ein wasserunlösliches, in wäßrigalkalischen Lösungen lösliches polymeres Bindemittel,

c) ein feinteiliges mineralisches Pigment auf Kieselsäure- bzw. Silikatbasis, dessen Oberfläche durch Umsetzen mit einer damit reaktiven Verbindung modifiziert worden ist, die zusätzlich eine radikalisch oder thermisch vernetzbare Gruppe enthält,

d) einen durch Strahlung aktivierbaren Polymerisationsinitiator, und

e) eine Verbindung enthält, die mit sich selbst, mit dem Bindemittel (b) oder mit dem Polymerisat der Verbindung (a) in der Wärme zu vernetzen vermag.

Das Gemisch wird zu Lötstoppmasken mit verbessertem Korrosionsschutz und erhöhtem Isolationswiderstand verarbeitet.

EP 0 549 946 A2

Die Erfindung betrifft ein durch Strahlung polymerisierbares Gemisch, das zur Herstellung von Lötstoppmasken verwendet wird und das als wesentliche Bestandteile

a) eine Verbindung mit mindestens einer endständigen ethylenisch ungesättigten Gruppe, die durch radikalisch initiierte Additionskettenpolymerisation ein vernetztes Polymerisat zu bilden vermag,

b) ein wasserunlösliches, in wäßrig-alkalischen Lösungen lösliches polymeres Bindemittel,

c) ein feinteiliges mineralisches Pigment auf Kieselsäure- bzw. Silikatbasis,

d) einen durch Strahlung aktivierbaren Polymerisationsinitiator oder eine Polymerisationsinitiatorkombination,

e) eine Verbindung, die mit sich selbst, mit dem Bindemittel (b) oder mit dem Polymerisat der Verbindung (a) in der Wärme zu vernetzen vermag,

f) ggf. einen durch Wärme aktivierbaren Vernetzungsinitiator für die Verbindung (e),

enthält.

Ein Gemisch dieser Zusammensetzung ist aus der EP-A 418 733 bekannt. Dieses Gemisch hat den Nachteil, daß das Pigment bei längerem Stehen der Masse zum Absitzen bzw. Auskreiden neigt, daß das Dispergieren oder Redispergieren des Pigments eine gewisse Zeit in Anspruch nimmt und daß die damit hergestellte Lötstoppmaske nach längerer Lagerung bei höherer Temperatur und bzw. oder hoher Luftfeuchte die von ihr abgedeckte Schaltung nicht sicher vor Korrosion schützt. Auch wird der Isolationswiderstand der Lötstoppmaske durch das Pigment herabgesetzt.

In der DE-A 27 48 523 wird eine Epoxid-Niederdruckpreßmasse beschrieben, die zum Umhüllen elektronischer Bauelemente geeignet ist. Sie enthält vorzugsweise 60 bis 70 Gew.-% eines Quarzmehl-Füllstoffs, der amorph ist und eine Oberflächenbeschichtung aus Aminosilan als Haftvermittler aufweist. Die Masse ist nicht lichtempfindlich und daher nicht zur bildmäßigen Strukturierung geeignet.

In der DE-A 36 15 790 wird eine durch Licht härtbare Beschichtungszusammensetzung beschrieben, die eine oligomere Epoxyverbindung, einen pulverisierten anorganischen Füllstoff, dessen Oberfläche mit einer Epoxygruppen enthaltenden Silylverbindung behandelt worden ist, und einen durch Belichtung anregbaren Initiator für die Härtung von Epoxygruppen enthält. Die Masse ist als kratzfester Überzug für Kunststoffe geeignet, kann jedoch nicht bildmäßig strukturiert werden.

Aufgabe der Erfindung war es, ein durch Strahlung polymerisierbares Gemisch für die Herstellung von Lötstoppmasken vorzuschlagen, das sich besser und anhaltender dispergieren läßt, das einen höheren Isolationswiderstand aufweist und das einen besseren Korrosionsschutz bietet als die bekannten Gemische und im übrigen alle Vorteile der bekannten Gemische aufweist.

Erfindungsgemäß wird ein durch Strahlung polymerisierbares Gemisch vorgeschlagen, das

a) eine Verbindung mit mindestens einer endständigen ethylenisch ungesättigten Gruppe, die durch radikalisch initiierte Additionskettenpolymerisation ein vernetztes Polymerisat zu bilden vermag,

b) ein wasserunlösliches, in wäßrig-alkalischen Lösungen lösliches polymeres Bindemittel,

c) ein feinteiliges mineralisches Pigment auf Kieselsäure- bzw. Silikatbasis,

d) einen durch Strahlung aktivierbaren Polymerisationsinitiator oder eine Polymerisationsinitiatorkombination,

e) eine Verbindung, die mit sich selbst, mit dem Bindemittel (b) oder mit dem Polymerisat der Verbindung (a) in der Wärme zu vernetzen vermag,

f) ggf. einen durch Wärme aktivierbaren Vernetzungsinitiator für die Verbindung (e),

enthält.

Das erfindungsgemäße Gemisch ist dadurch gekennzeichnet, daß die Oberfläche des Pigments (c) durch Umsetzen mit einer damit reaktiven Verbindung modifiziert worden ist, die zusätzlich eine radikalisch oder thermisch vernetzbare Gruppe enthält.

Erfindungsgemäß wird weiterhin ein Verfahren zur Herstellung einer Lötstoppmaske vorgeschlagen, das dadurch gekennzeichnet ist, daß man eine Lösung bzw. Dispersion eines Gemischs der vorstehend angegebenen Zusammensetzung auf die Oberfläche einer gedruckten Schaltung aufbringt und trocknet, die erhaltene Schicht bildmäßig mit aktinischer Strahlung unter Aussparung der Lötaugen bestrahlt, die unbestrahlten Schichtbereiche mit einem Entwickler auswäscht und die erhaltene Maske auf erhöhte Temperatur erwärmt.

Als mineralisches Pigment sind Silikate oder Kieselsäuren geeignet. Sie sollten zu einer solchen Teilchengröße vermahlen sein, daß mindestenss 80 % der Teilchen einen Durchmesser von 10 $\mu$m oder darunter haben. Dadurch erhält die Lötmaske eine glatte Oberfläche. Diese silikatischen Mineralien enthalten praktisch alle chemisch gebundenes Wasser in Form von OH-Gruppen am Silicium.

Beispielsweise können eingesetzt werden: Kieselerden, Talke, Quarze, Kaoline, Wollastonite, Feldspate, Amphibole, Serpentin, Zeolite, Bimse und Phenolithe. Der $SiO_2$-Gehalt liegt dabei meist oberhalb 60 %. Als Gegenionen, die im Kristallverband enthalten sind, fungieren vorteilhaft Aluminium, Erdalkali- und Alkalime-

2

talle. Der Mengenanteil des Pigments beträgt allgemein etwa 20 bis 50, vorzugsweise 25 bis 40 Gew.-%.

Die Oberflächenbehandlung der Pigmente erfolgt in bekannter Weise. Geeignete Behandlungsverfahren sind in den DE-A 33 25 064, 36 11 999, der DE-B 23 04 602 und dem Artikel "Silanbehandelte Füllstoffe und deren Verwendung in der Farbenindustrie" von Hofmann und Merzbach in Coating, 1990, S. 348-350 beschrieben. Als reaktive Modifiziermittel werden bevorzugt Silane, insbesondere solche mit Alkoxygruppen oder Halogenatomen am Silicium eingesetzt. Als radikalisch oder thermisch vernetzbare Gruppen sind bevorzugt Epoxygruppen, Vinyl-, Acryloyl- oder Methacryloylgruppen geeignet, die in organischen Resten am Silicium enthalten sind. Im allgemeinen wird die Modifizierung so weit getrieben, daß die Oberfläche im wesentlichen vollständig mit modifizierenden Gruppen bedeckt ist.

Als polymerisierbare Verbindungen werden im allgemeinen Ester der Acryl- oder Methacrylsäure mit mehrwertigen, vorzugsweise primären, Alkoholen verwendet. Der Alkohol sollte mindestens zwei Hydroxygruppen enthalten, da durch mehrfach ungesättigte Verbindungen die erwünschte Vernetzungswirkung erreicht wird. Bevorzugt werden mindestens zweifach ungesättigte Verbindungen; es können aber auch einfach ungesättigte, z. B. Ester von einwertigen Alkoholen im Gemisch enthalten sein. Beispiele für geeignete mehrwertige Alkohole sind Ethylenglykol, Propylenglykol, Butandiol-1,4, Diethylenglykol, Triethylenglykol, Oligopropylenglykole, Trimethylolethan und -propan, Pentaerythrit, Dipentaerythrit, Bisphenol-A- bis-hydroxyethylether. Es sind ferner die niedermolekularen, Urethangruppen enthaltenden Bis-acrylate und Bis-methacrylate geeignet, die durch Umsetzen von 2 mol Hydroxyalkylacrylat oder -methacrylat mit 1 mol eines aliphatischen oder cycloaliphatischen Diisocyanats, z. B. 2,2,4-Trimethyl-hexamethylendiisocyanat, erhalten werden. Derartige Urethangruppen enthaltende Monomere sind in der US-A 4 088 498 beschrieben. Besonders vorteilhaft sind Acrylate und Methacrylate, insbesondere Acrylate, mit hohem Doppelbindungsgehalt. So werden Monomere mit 3 oder mehr ungesättigten Gruppen bevorzugt. Auch sind im allgemeinen Ester, die noch mindestens eine freie Hydroxygruppe enthalten, den vollständig veresterten Verbindungen überlegen. Die Ester des Trimethylolpropans, Trimethylolethans, des Pentaerythrits und Dipentaerythrits werden besonders bevorzugt. Das Monomere ist im allgemeinen in einer Menge von 10 bis 35, vorzugsweise von 15 bis 30 Gew.-%, bezogen auf den Gesamtgehalt an nichtflüchtigen Bestandteilen, in dem Gemisch enthalten.

Wesentlich für die Brauchbarkeit des erfindungsgemäßen Gemischs ist das polymere Bindemittel. Es ist in Wasser unlöslich und bevorzugt in wäßrig-alkalischen Lösungen löslich. Hierzu eignen sich vor allem Polymere mit seitenständigen Carboxyl- oder Carbonsäureanhydridgruppen. Besonders bevorzugt werden Copolymere der Acryl- und Methacrylsäure, die als Comonomere Acryl- oder Methacrylsäureester, Styrole, Acryl- oder Methacrylnitril, Acryl- oder Methacrylamid oder Vinylheterocyclen enthalten. Als (Meth)- acrylsäureester werden Alkylester mit vorzugsweise 1 bis 10, insbesondere 1 bis 7 Kohlenstoffatomen, in der Alkylgruppe eingesetzt. Das Styrol kann ein o-, m- oder p-Vinyltoluol, ein Vinylethylbenzol, das α- Methyl- oder α-Chlorstyrol, ein o-, m- oder p-Chlorstyrol, ein Vinylanisol oder dgl. sein. Das unsubstituierte Styrol wird im allgemeinen bevorzugt. Der Mengenanteil an Styroleinheiten liegt im Bereich von 40 bis 65, vorzugsweise von 45 bis 55 Gew.-%; der des (Meth)acrylsäureesters bei 5 bis 40, vorzugsweise zwischen 5 und 25 Gew.-%. Die (Meth)acrylsäureeinheiten sollten in solcher Menge vorliegen, daß die Säurezahl des Polymeren im Bereich von 110 bis 280, vorzugsweise von 125 bis 260 liegt. Der Mengenanteil des Polymeren im Gemisch beträgt im allgemeinen 15 bis 50, vorzugsweise 20 bis 40 Gew.-%.

Als durch Strahlung aktivierbare Polymerisationsinitiatoren können zahlreiche Substanzen Verwendung finden. Beispiele sind Benzoine, Benzoinether, Mehrkernchinone, wie 2-Ethylanthrachinon, Acridinderivate, wie 9-Phenylacridin oder Benzacridine, Phenazinderivate, wie 9,10-Dimethylbenz(a)phenazin, Chinoxalin- oder Chinolinderivate, wie 2,3-Bis-(4-methoxyphenyl)chinoxalin oder 2-Styrylchinolin, Chinazolinverbindungen oder Acylphosphinoxidverbindungen. Photoinitiatoren dieser Art sind in den DE-C 20 27 467, 20 39 861, der DE-A 37 28 168, der EP-B 11 786 und der EP-A 220 589 beschrieben. Außerdem können z. B. Hydrazone, Mercaptoverbindungen, Pyrylium- oder Thiopyryliumsalze, Xanthone, Thioxanthone, Benzochinone, Acetophenone, Benzophenone, synergistische Mischungen mit Ketonen oder Hydroxyketonen und Farbstoff-Redoxsysteme eingesetzt werden. Besonders bevorzugt werden Photoinitiatoren, die durch Licht spaltbare Trihalogenmethylgruppen aufweisen, wobei insbesondere entsprechende Verbindungen aus der Triazin- oder Thiazolinreihe erwähnt sein sollen. Solche Verbindungen sind in den DE-A 27 18 259, 33 33 450 und 33 37 024 beschrieben. Ein bevorzugtes Beispiel ist 2-(4-Methoxystyryl)4,6-bis-trichlormethyl-s- triazin.

Die Photoinitiatoren werden im allgemeinen in Mengenanteilen von 0,1 bis 15, vorzugsweise von 0,5 bis 10 Gew.-%, bezogen auf die nichtflüchtigen Bestandteile des Gemischs, zugesetzt.

Das erfindungsgemäße Gemisch enthält ferner eine thermisch vernetzbare Verbindung. Bevorzugt werden zwei- oder mehrwertige Epoxyverbindungen. Als Beispiele sind insbesondere Bisglycidylether von zweiwertigen Alkoholen und Phenolen, z. B. von Bisphenol A, von Polyethylenglykol- und Polypropylenglykolethern des Bisphenols A, von Butan-1,4-diol, Hexan-1,6-diol, Polyethylenglykol, Polypropylenglykol oder Polytetrahydrofuran geeignet.

Auch Bisglycidylether von dreiwertigen Alkoholen, z. B. von Glycerin, können verwendet werden. Die Epoxide werden dem Gemisch gewöhnlich in einer Menge von etwa 10 bis 30, vorzugsweise 12 bis 25 Gew.-%, bezogen auf die nichtflüchtigen Bestandteile des Gemisches, zugesetzt.

Bevorzugte Bisepoxide sind in der EP-A 418 733 beschrieben.

Als weitere thermisch vernetzbare Verbindungen sind solche mit kondensationsfähigen N-Hydroxymethyl- oder N-Alkoxymethylgruppen geeignet. Beispiele sind Hexamethoxymethyl- und Hexahydroxymethylmelamin.

Wenn als Vernetzer Epoxyverbindungen eingesetzt werden, enthält das Gemisch bevorzugt einen Härter oder Additionsinitiator für Epoxygruppen. Der Härter ist bevorzugt eine Stickstoffbase, z. B. Triethylamin, 1,4-Diazabicyclo[2.2.2]octan(Dabco), Dibutylamin, höher alkylierte Mono-, Di- und Triamine auf aliphatischer Basis, ferner aliphatisch-aromatische Amine wie z. B. Dimethylanilin. Die tertiären, insbesondere aliphatischen Amine werden bevorzugt. Ganz besonders bevorzugt wird das Diazabicyclooctan. Die Menge der Base liegt im allgemeinen zwischen 0,15 und 1,5, vorzugsweise zwischen 0,2 und 1,0 Gew.-%.

Vorzugsweise enthält das Gemisch mindestens einen Farbstoff, um die entwickelte Resistschablone besser sichtbar zu machen. Dabei wird mit Vorteil eine Kombination von mindestens zwei Farbstoffen verwendet, von denen der eine bei Bestrahlung seine Farbe ändert und bei Temperaturen oberhalb 200 °C zerstört, d. h. farblos wird. Der andere Farbstoff soll sowohl die Bestrahlung als auch Temperaturen oberhalb 200 °C ohne Veränderung überstehen. Er soll die Lötstoppmaske während des Lötens und danach deutlich sichtbar machen. Hierfür geeignete Farbstoffe sind in der DE-A 3 114 931 beschrieben.

Das Gemisch kann gegebenenfalls eine Reihe weiterer üblicher Zusätze enthalten, z. B. Inhibitoren zur Verhinderung der thermischen Polymerisation der Monomeren, Wasserstoffdonatoren, Lichtempfindlichkeitsregler, Pigmente, Weichmacher und Thixotropiermittel, insbesondere mineralische, ggf. hydrophobierte Pigmente, wie $SiO_2$, oder organische Polymere, wie Polyacrylamide. Thixotropiermittel sind z. B. beim Antrag durch Vorhanggießen von Vorteil.

Das erfindungsgemäße Gemisch ist in der verarbeitungsfertigen Form nur begrenzt haltbar; daher werden die Einzelkomponenten zweckmäßig in mindestens zwei Gebinden - "Zweikomponentenlack" - getrennt aufbewahrt. Normalerweise wird so verfahren, daß alle Komponenten, mit Ausnahme der Epoxidverbindung, in einer Hauptmischung vorliegen, der kurz vor der Verarbeitung das Epoxid beigemischt wird. Man kann aber auch z. B. den Härtungsinitiator als getrennte Komponente halten. Auch Farbstoffe, mineralischer Feststoff und andere Zusatzstoffe können in getrennten Mischkomponenten vorliegen, so daß gegebenenfalls auch ein Dreikomponentensystem rezepturiert werden kann. Wichtig ist, daß die Teilgemische vor dem Mischprozeß eine hinreichend lange Haltbarkeit (ca. 6 bis 12 Monate) besitzen.

Die Verarbeitung des erfindungsgemäßen Gemischs erfolgt in bekannter Weise, z. B. im Siebantrag. Das gelöste bzw. dispergierte Gemisch wird z. B. durch ein in einem Metallrahmen gespanntes Siebgewebe von 37 bis 55 Maschen je cm mit einer Rakel auf das Leiterplattenobjekt aufgebracht. Eine andere Möglichkeit ist die Vorhangbeschichtung. Mit Hilfe einer handelsüblichen Vorhanggießmaschine wird ein kontinuierlich vertikal laufender Flüssigkeitsfilm erzeugt. Mittels eines Förderbandes wird die Leiterplatte unter diesem Film durchgeführt und damit beschichtet. Das Gemisch kann schließlich auch über eine Sprühbeschichtung, vorzugsweise eine elektrostatische Sprühbeschichtung, aufgebracht werden. In einer geschlossenen Kabine wird die Lösung an einem Sprühkopf in feinste Tröpfchen zerteilt, diese durch Hochspannung elektrostatisch aufgeladen und auf der Leiterplatte abgeschieden. Auch im Tauchziehverfahren und durch Walzenantrag lassen sich die Mischungen verarbeiten.

Die nach einem der geschilderten Verfahren verarbeiteten Beschichtungsgemische werden durch Trocknen im Umlufttrockenschrank und bzw. oder unter einem IR-Trockner vom Lösemittel befreit. Die so beschichtete Leiterplatte wird dann durch eine Vorlage belichtet, die die Teile der Platte vor der Bestrahlung schützt, die für den Lötvorgang freibleiben müssen.

Als aktinische Strahlung, gegenüber der das erfindungsgemäße Gemisch empfindlich ist, kommt jede elektromagnetische Strahlung in Betracht, deren Energie zur Anregung eines geeigneten Polymerisationsinitiators ausreicht. Geeignet ist insbesondere sichtbares und ultraviolettes Licht, Röntgen-, $\gamma$- und Elektronenstrahlung. Auch Laserstrahlung im sichtbaren und UV-Bereich kann verwendet werden. Bevorzugt wird kurzwelliges sichtbares und nahes UV-Licht.

Entwickelt werden die Schichten in bekannter Weise. Als Entwickler für die bevorzugten Schichten sind wäßrige, vorzugsweise wäßrig-alkalische Lösungen, z. B. von Alkaliphosphaten, -carbonaten oder -silikaten, geeignet, denen gegebenenfalls kleine Mengen, z. B. bis zu 10 Gew.-%, an mit Wasser mischbaren organischen Lösemitteln oder Netzmitteln zugesetzt werden können.

Fertig entwickelte Lötmasken werden vor dem Lötprozeß einer Temperaturbehandlung unterzogen. Dabei reagieren z. B. die Carboxylgruppen des Bindemittels mit dem mehrfunktionellen Epoxid zu einem interpenetrierenden Netzwerk. Integrierender Bestandteil dieses Netzwerkes ist auch der mineralische Feststoff.

Insgesamt werden durch die thermische Nachbehandlung die guten mechanischen, thermischen und chemischen Eigenschaften der Lötstoppmasken bewirkt. Diese thermische Behandlung erfolgt im allgemeinen zwischen 80 °C und 180 °C, bei ungefähren Behandlungszeiten von 10 bis 90 Minuten. Die lötbereite Platte wird anschließend verzinnt und kann dann mit elektronischen Bauelementen in bekannter Weise bestückt werden.

Die Leitungsseite der Platte wird anschließend üblicherweise mit einem passenden, handelsüblichen Flußmittel behandelt und z. B. über eine handelsübliche Schwall-Lötmaschine der Schwall-Lötung unterworfen. Als Lötmittel dienen bekannte eutektische Gemische, die Löttemperaturen von etwa 230 bis 260 °C gestatten. Ein bekanntes Gemisch enthält beispielsweise 63 Gew.-% Zinn und 37 Gew.-% Blei. Besonders bei Verfahren, bei denen doppelseitige, durchkontaktierte Leiterplatten durch Eintauchen in flüssige Metallbäder gelötet werden, lassen sich die erfindungsgemäß hergestellten Lötstoppmasken mit Erfolg einsetzen.

Die erfindungsgemäßen Gemische ergeben Lötstoppresistschichten, die sich durch hohe Flexibilität und mechanische Festigkeit im unbelichteten und belichteten Zustand und durch eine hohe Temperaturresistenz im belichteten und nachgehärteten Zustand auszeichnen. Die photopolymerisierbaren Schichten weisen in Kombination mit den bevorzugten Photoinitiatoren eine hohe Lichtempfindlichkeit auf und ergeben auch bei hoher Schichtdicke eine gute Durchhärtung bzw. Durchvernetzung. Die belichteten Schichten lassen sich auch bei Schichtdicken oberhalb 100 $\mu$m einwandfrei und vollständig mit wäßrig-alkalischen Lösungen entwickeln.

Die belichteten und entwickelten Schichten lassen sich ohne übermäßige Beeinträchtigung der Flexibilität der Maske oder ihrer Haftung auf der Unterlage und ohne Veränderung der Lage und Dimensionen der durch Entwicklung freigelegten Bereiche thermisch härten. Die gehärteten Masken sind gegenüber atmosphärischen, thermischen und chemischen Einflüssen über längere Zeiträume beständig. Nach dem Belichten der Resistschicht wird ein kontrastreiches Bild in der Schicht erhalten. Die aus den erfindungsgemäßen Gemischen erhaltenen Lötstoppmasken eignen sich in besonderem Maße dazu, empfindliche elektronische Leiterstrukturen vor atmosphärischen Angriffen wirksam und dauerhaft zu schützen.

Die folgenden Beispiele erläutern einzelne Ausführungsformen des erfindungsgemäßen Gemisches. Wenn nichts anderes angegeben ist, sind Prozentzahlen und Mengenverhältnisse in Gewichtseinheiten zu verstehen. Gewichtsteile (Gt) und Volumenteile (Vt) stehen im Verhältnis von g zu ml.

Beispiel 1 (Vergleichsbeispiel)

Herstellung einer verarbeitungsfertigen Lötstoppmaske

a) 320 Gt Styrol, 150 Gt Methacrylsäure, 30 Gt n-Hexylmethacrylat und 15 Gt 2,2-Azo-bis-isobuttersäurenitril wurden unter Rühren in 450 Gt 3-Methoxybutanol-1 gelöst. 1/3 dieser Lösung wurde in einem Rundkolben unter Rühren und Hindurchleiten von Stickstoff auf 90 °C erwärmt. Die einsetzende exotherme Polymerisation wurde durch äußere Kühlung bei 90 °C bis maximal 100 °C gehalten. Nach Abklingen der Hauptreaktion wurden die zurückbehaltenen 2/3 der Lösung innerhalb 1 1/2 Stunden gleichmäßig zudosiert und anschließend die Reaktionslösung noch 12 bis 14 Stunden bei 90 °C gehalten. Die Polymerlösung war nach Abkühlen auf Zimmertemperatur gebrauchsfertig.

Die reduzierte spezifische Viskosität des Produkts betrug 0,185 dl/g (gemessen an einer 1 %igen Lösung in Dimethylformamid bei 25 °C).

b) In einem zylindrischen Gefäß wurden in 123,9 Gt 3-Methoxy-butanol-1

112,5 Gt Pentaerythrit-triacrylat,

128,9 Gt Trimethylolpropan-triacrylat,

27,5 Gt 9-Phenylacridin,

12,4 Gt Neozapongrün,

1,2 Gt eines blauen Azofarbstoffs, erhalten durch Kuppeln von 2,4-Dinitro-6-chlor-benzoldiazoniumsalz mit 2-Methoxy-5-acetylamino-N,N-diethylanilin und

2,5 Gt Triethylendiamin

mit einem hochtourigen Schnellrührer in Lösung gebracht. Dann wurden im Verlauf von 30 Minuten 396,7 Gt eines silikatischen Pigments, das ein natürliches Agglomerat von korpuskularem Quarz und laminarem Kaolinit ist, in die gerührte Lösung eingestreut. Es enthält über 80 % $SiO_2$ und ca. 11 % $Al_2O_3$; ca. 90 Gew.-% der Teilchen haben eine Korngröße unterhalb 5 $\mu$m (Sillitin). Dieser Suspension

wurden anschließend 694,2 Gt der unter a) beschriebenen Polymerlösung zugesetzt. Der nun mit allen Komponenten versehene Ansatz wurde mit Hilfe des Mischers gut homogenisiert (1.200 U/min), wobei darauf geachtet wurde, daß die Temperatur des Ansatzes nicht über 50 bis 55 °C anstieg.

Der viskose Lack wurde zur weiteren Homogenisierung in einer Glaskugelmühle vermahlen und dann durch ein 160 μm V2A-Gewebe-Druckfilter filtriert und abgefüllt. Diese Mischung wurde, soweit erforderlich, mit Methoxybutanol auf einen Feststoffgehalt von 68,6 Gew.-% verdünnt und im Folgenden als Komponente A bezeichnet.

c) In einem zylindrischen Gefäß wurden 252 Gt eines epoxydierten Phenol-Formaldehyd-Harzes mit dem Epoxid-Äquivalentgewicht 172 bis 179 in 148 Gt 3-Methoxybutanol mittels eines Ankerrührers gelöst. Nach 15 Minuten Rührzeit lag eine klare Lösung mit 63 % Feststoffgehalt vor. Diese Lösung wurde im Folgenden als Komponente B bezeichnet.

d) 100 Gt der Komponente A wurden mit 22,3 Gt der Komponente B mit einem passenden Rührer intensiv gemischt. Damit war die Lötstopplösung zum Gebrauch, also zum Antrag auf eine Leiterplatte nach einem der oben erwähnten Verfahren, fertig. Der Feststoffgehalt betrug 67,5 %.

e) Eine 24 x 36 cm große Platte aus Epoxidharz-Glasgewebe mit einem beidseitig aufgebrachten Schaltbild aus 0,2 bis 1,5 mm breiten und 50 bis 90 μm dicken Kupferbahnen und durchkontaktierten Bohrungen wurde mit der unter d) beschriebenen Lösung mittels einer halbautomatischen Siebdruckmaschine (Alfra-Plan 50/70) vollflächig beschichtet. Zur Lackübertragung wurde ein vollflächig offenes Polyestersieb mit 43 Maschen je cm verwendet; die Gummirakel mit einer Härte von 70 Shore war an der Druckkante leicht abgerundet, und der Antragswinkel betrug 15°. Auf diese Weise ließen sich blasen- und farbschattenfreie Beschichtungen mit einer Flankenabdeckung von 15 bis 20 μm erzielen. Die so beschichtete Leiterplatte wurde 5 Minuten bei Raumtemperatur belassen und anschließend 7 Minuten in einem Umlufttrockenschrank bei 80 °C getrocknet. Nach dem Abkühlen auf Raumtemperatur wurde die beschichtete Leiterplatte durch eine Filmvorlage bildmäßig belichtet.

Entwickelt wurde in einer Durchlaufsprühanlage mit 1 %iger wäßriger Sodalösung bei 30 °C mit 1,2 bar Sprühdruck. Die Entwicklungszeit betrug 90 s; die unbelichteten Schichtbereiche waren bereits nach etwa 2/3 der Entwicklerstrecke frei entwickelt.

Nach Waschen mit Wasser wurde die entwickelte Platte in einem Warmluftdurchlauftrockner getrocknet und anschließend in einem Umlufttrockenofen 1 Stunde bei 150 °C getempert. Die nun vollständig ausgehärtete Platine wurde schwallgelötet, eine zweite Platine, die in gleicher Weise hergestellt worden war, wurde heißverzinnt.

Das Löten wurde auf einer Schwall-Lötmaschine durchgeführt. Dazu wurde die Platte über einen vorgeschalteten Schaumfluxer (Alphagrillo[R] TL 33) geführt, vorgetrocknet und über das aus eutektischer Blei/Zinnlegierung bestehende flüssige Lot gefahren. Die Geschwindigkeit betrug 0,9 m je Minute, die Lottemperatur 260 °C. Zwecks Beseitigung der noch anhaftenden Flußmittelreste wurde 3 Minuten mit einer Mischung aus 65 % Trichlortrifluorethan und 35 % 2-Propanol und dann 3 Minuten mit reinem Trichlortrifluorethan gewaschen. Das Lötergebnis der so verarbeiteten Leiterplatte war sehr gut.

Mit der zweiten Platine wurde eine Heißluftverzinnung ("Hot-Air-Levelling") durchgeführt. Dazu wurde die Platine mittels Gummiwalzen mit einem wasserlöslichen Flußmittel (Robertson SM 287) benetzt und durch Eintauchen in flüssiges Lot und anschließendes Abblasen mit heißer Luft verzinnt. Die Lottemperatur betrug 250 °C, die Temperatur der an den beiden Luftmessern mit hohem Druck austretenden Luft 260 °C, die Eintauchzeit war auf 5 s eingestellt. Nach Waschen mit Wasser und Trocknen zeigte auch diese Platte eine völlig einwandfreie Oberfläche.

f) Wird der unter d) beschriebene, für den Siebantrag direkt verwendbare Lack für ein anderes Antragsverfahren verwendet, so ist der Feststoffgehalt von 67,5 % zu hoch. Wird die Maske durch einen vertikal fallenden Vorhang aus dem Längsspalt einer Vorhanggießmaschine auf die Leiterplatte angetragen, muß der Feststoff durch Verdünnen mit Methoxybutanol auf ca. 58 Gew.-% gesenkt werden. Ähnliche Konzentrationen sind erforderlich, wenn die Maske im Hochspannungsfeld mittels eines rotierenden Sprühkopfes auf die Leiterplatte gesprüht wird. Auch diese Techniken führen zu einer sehr guten Leiterbahnumhüllung durch die Maske, die die Platte porenfrei und in gleichmäßiger Stärke abdeckt. Die Verarbeitung gemäß e) führt zu demselben guten Ergebnis.

Der Isolationswiderstand und die elektrolytische Korrosion (E-Korrosion) der Lötstopmasken wurden wie im folgenden beschrieben bestimmt: Das Verfahren entspricht im wesentlichen der Standardvorschrift für Leiterplatten IPC SM-840 B.

Zur Messung des Isolationswiderstands werden an die Anschlußkontakte der fertigen, noch nicht bestückten standardisierten Schaltungen 100 V Gleichspannung angelegt. Dabei wird eine erste Messung nach 24-stündiger Lagerung bis 23 °C und 50 % relativer Feuchte, eine zweite nach 4-tätiger Lagerung bei 40 °C und 92 % relativer Feuchte durchgeführt. Die Messung erfolgt 30 s nach Anlegen der Spannung im jeweiligen Klima. Die elektrolytische Korrosion (E-Korrosion) der von der Lötstoppmaske abgedeckten Kupferlinien wurde wie folgt ermittelt: Die Testplatten wurden 4 Tage bei 40 °C und 92 % relativer Feuchte gelagert, wobei an jeweils zwei parallel verlaufende Leiterbahnen 100 V Gleichspannung angelegt werden. Die Korrosion wurde visuell beurteilt. Die Ergebnisse sind in Tabelle I zusammengestellt.

Beispiele 2 bis 24

Die Beispiele 17-20 und 24 sind Vergleichsbeispiele mit unbehandelten Pigmenten.

In allen Beispielen wurde mit der gleichen Rezeptur wie in Beispiel 1 gearbeitet, jedoch wurde das dort verwendete Silikatpigment durch jeweils die gleiche Menge eines der in Tabelle I angegebenen Pigmente ersetzt. Für den Siebantrag wurde die Viskosität der Komponente A durch Zusatz von 3-Methoxy-butanol-1 auf 200 ± 10 dPas eingestellt. Soweit in Tabelle I angegeben, wurden kleinere Mengen eines weiteren Pigments zugesetzt. Dieses Pigment (Crossfield HP 200) ist ein amorphes Silikat, dessen Oberfläche mit einem wachsartigen Polyolefin überzogen ist und das eine Korngröße von 10 $\mu$m aufweist.

Die Modifizierung gemäß der Erfindung erfolgte in jedem Fall durch Umsetzen der Pigmentoberfläche mit einer ungesättigten Verbindung mit einer endständigen reaktiven Alkoxysilylgruppe oder Chlorsilylgruppe. Die Umsetzung wird in bekannter Weise so lange durchgeführt, bis die Oberfläche im wesentlichen mit ungesättigten Resten bedeckt und hydrophob geworden ist. Um die Topfzeit zu erhöhen, wurden die mit Epoxyverbindungen modifizierten Pigmente in einigen Fällen auch statt der Komponente A der Komponente B zugesetzt. Abgesehen von einer erhöhten Topfzeit waren in diesen Fällen die Ergebnisse gleich. Die Art der zur Oberflächenmodifikation eingesetzten ungesättigten Verbindungen ist im folgenden angegeben. Die elektrolytische Korrosion der von der Lötstoppmaske abgedeckten Kupferlinien wurde visuell beurteilt und auf einer Skala von 0 bis 6 angegeben. Dabei bedeutet:

0 - keine Korrosion

1 - sehr vereinzelte Korrosionspunkte (2-3 Punkte auf 16 mm Länge)

2 - wenige einzelne Korrosionspunkte (4-6)

3 - etwas häufigere getrennte Korrosionspunkte (7-11)

4 - häufige Korrosionspunkte (12-19), teils zu größeren Korrosionsstellen miteinander verbunden

5 - sehr viele Korrosionspunkte (20-30) mit vielen größeren Korrosionsstellen

6 - großflächige bis ganzflächige Korrosion.

Alle Lötstoppmasken wurden je einmal im Siebdruck, durch Vorhanggießen und durch elektrostatische Sprühbeschichtung aufgebracht, wobei unabhängig von der Beschichtungsmethode im wesentlichen die gleichen Ergebnisse erzielt wurden. Die Dicke der Beschichtung auf den Leiterbahnen lag im Bereich von 20 bis 25 $\mu$m; an den Kanten lag sie zwischen 15 und 20 $\mu$m. Alle Schichten hatten nach dem Belichten, Entwickeln und Aushärten (1 Stunde bei 150 °C) eine Bleistifthärte von mehr als 6 H.

Im einzelnen wurden die folgenden Pigmente eingesetzt:

A: natürliches Agglomerat von korpuskularem Quarz und laminarem Kaolinit (über 80 % $SiO_2$; ca. 11 % $Al_2O_3$;ca. 90 Gew.-% der Partikel haben eine Korngröße unterhalb 5 $\mu$m - Sillitin[(R)]),

B: Quarz, umgesetzt mit Methacryloylgruppen enthaltendem Silan (Silbond[(R)] 600 MST),

C: Natürlicher Wollastonit, Teilchengröße unter 10 $\mu$m, umgesetzt mit Methacryloylgruppen enthaltendem Silan (Tremin[(R)] 283-600 MST),

D: Mit einem Epoxygruppen enthaltenden Silan umgesetzter Quarz, Teilchengröße unter 10 $\mu$m, mehr als 70 % unter 4 $\mu$m (Silbond 600 EST),

E: Calciniertes Aluminiumsilikat, umgesetzt mit Epoxygruppen enthaltendem Silan (Silbond FW 600 EST),

F: Wollastonit wie unter C, umgesetzt mit Epoxygruppen enthaltendem Silan (Tremin 283-600 EST),

G: Kaolin, umgesetzt mit Vinylgruppen enthaltendem Silan (Translink[(R)] 77),

H: Kaolin, umgesetzt mit Vinylgruppen enthaltendem Silan (Translink 73),

I: Calciniertes Aluminiumsilikat, umgesetzt mit Epoxygruppen enthaltendem Silan, ähnlich E (Silbond FW 300 EST),

K: Mit Epoxygruppen enthaltendem Silan behandelter natürlicher Wollastonit, Teilchengröße unter 16 $\mu$, ca. 65 % unter 8 $\mu$m (Tremin 283-400 EST),

L: Aluminiumsilikat, umgesetzt mit Epoxygruppen enthaltendem Silan (Silmikron VP 795-10/1 EST),

M: Talk, umgesetzt mit Methacryloylgruppen enthaltendem Silan (Naintsch[(R)] V 563),

N: Talk, umgesetzt mit Epoxygruppen enthaltendem Silan (Naintsch[(R)] V 614),

O: Talk, umgesetzt mit Epoxygruppen enthaltendem Silan (Naintsch[(R)] V 616),

P: Kaolin, nicht oberflächenbehandelt (Satinetone[(R)] Nr. 5),

Q: Aluminiumsilikat, nicht oberflächenbehandelt (Sillitin Z 89),

R: amorphes Silikat, nicht oberflächenbehandelt (Syloid AL 1),
S: Kieselerde, umgesetzt mit höhere Acryloylreste enthaltendem Silan (Aktisil[R] TP 91/18),
T: Kieselerde, umgesetzt mit Epoxygruppen enthaltendem Silan (Aktisil TP 91/17),
U: Kieselerde, umgesetzt mit Epoxygruppen enthaltendem Silan (Aktisil TP 91/23),
V: amorphes Silikat, nicht oberflächenbehandelt (Gasil[R] 200 DF),

**Tabelle I**

| Beispiel Nr. | Pigment | Zusatzpigment Gewichtsteile | Entwicklungszeit (s) 1 % $Na_2CO_3$ 30° C | Isolationswiderstand Raumklima 24h $\Omega \times 10^{-13}$ | Isolationswiderstand 40 °C/92 %, 4 Tage $\Omega \times 10^{-9}$ | E-Korrosion |
|---|---|---|---|---|---|---|
| 1 (V) | A | 0 | 65 | 3,5 | 2,3 | 4 |
| 2 | B | 5 | 55 | über 50 | 40 | 0 |
| 3 | C | 10 | 56 | 20 | 24 | 0 |
| 4 | D | 5 | 57 | 50 | 75 | 0 |
| 5 | E | 5 | 68 | 15 | 57 | 0 |
| 6 | F | 5 | 54 | 50 | 7,5 | 0 |
| 7 | B | 0 | 67 | 20 | 65 | 0 |
| 8 | G | 0 | 65 | 50 | 18 | 0 |
| 9 | G | 5 | 54 | 45 | 120 | 0 |
| 10 | H | 0 | 56 | 30 | 25 | 0 |
| 11 | I | 5 | 63 | 50 | 55 | 0 |
| 12 | K | 5 | 60 | 75 | 7,5 | 0 |
| 13 | L | 5 | 63 | 50 | 50 | 0 |
| 14 | M | 0 | 54 | 50 | 230 | 0 |

8

Tabelle I (Fortsetzung)

| Bei-spiel Nr. | Pigment | Zusatz-pigment Gewichts-teile | Entwick-lungs-zeit (s) 1 % $Na_2CO_3$ 30° C | Isolationswiderstand | | E-Korrosion |
|---|---|---|---|---|---|---|
| | | | | Raum-klima 24h $\Omega$ x $10^{-13}$ | 40 °C/92 %, 4 Tage $\Omega$ x $10^{-9}$ | |
| 15 | N | 0 | 56 | 50 | 57 | 0 |
| 16 | O | 0 | 67 | 30 | 24 | 0 |
| 17(V) | P | 0 | 69 | 7,5 | 7 | 4 |
| 18(V) | Q | 5 | 63 | 3,5 | 2,3 | 4 |
| 19(V) | Q | 0 | 55 | 4,8 | 8,0 | 2 |
| 20(V) | R | 0 | 56 | 6,0 | 5,0 | 4 |
| 21 | S | 0 | 70 | 25 | 25 | 0 |
| 22 | T | 0 | 58 | 40 | 30 | 0 |
| 23 | U | 0 | 62 | 50 | 57 | 0 |
| 24(V) | V | 0 | 59 | 10 | 75 | 4 |

**Patentansprüche**

1. Durch Strahlung polymerisierbares Gemisch, enthaltend

a) eine Verbindung mit mindestens einer endständigen ethylenisch ungesättigten Gruppe, die durch radikalisch initiierte Additionskettenpolymerisation ein vernetztes Polymerisat zu bilden vermag,
b) ein wasserunlösliches, in wäßrig-alkalischen Lösungen lösliches polymeres Bindemittel,
c) ein feinteiliges mineralisches Pigment auf Kieselsäure- bzw. Silikatbasis,
d) einen durch Strahlung aktivierbaren Polymerisationsinitiator oder eine Polymerisationsinitiatorkombination,
e) eine Verbindung, die mit sich selbst, mit dem Bindemittel (b) oder mit dem Polymerisat der Verbindung (a) in der Wärme zu vernetzen vermag,
f) ggf. einen durch Wärme aktivierbaren Vernetzungsinitiator für die Verbindung (e),
dadurch gekennzeichnet, daß die Oberfläche des Pigments (c) durch Umsetzen mit einer damit reaktiven Verbindung modifiziert worden ist, die zusätzlich eine radikalisch oder thermisch vernetzbare Gruppe enthält.

2. Durch Strahlung polymerisierbares Gemisch nach Anspruch 1, dadurch gekennzeichnet, daß die reaktive Verbindung eine Silylverbindung ist.

3. Durch Strahlung polymerisierbares Gemisch nach Anspruch 1, dadurch gekennzeichnet, daß die radikalisch vernetzbare Gruppe eine Acryloyl-, Methacryloyl- oder Vinylgruppe ist.

4. Durch Strahlung polymerisierbares Gemisch nach Anspruch 1, dadurch gekennzeichnet, daß die thermisch vernetzbare Gruppe eine Epoxygruppe ist.

5. Durch Strahlung polymerisierbares Gemisch nach Anspruch 1, dadurch gekennzeichnet, daß das Bindemittel (b) ein Mischpolymerisat der Acryl- oder Methacrylsäure ist.

6. Durch Strahlung polymerisierbares Gemisch nach Anspruch 1, dadurch gekennzeichnet, daß die thermisch vernetzende Verbindung eine Epoxyverbindung oder eine Verbindung mit N-Hydroxymethyl- oder N-Alkoxymethylgruppen ist.

7. Durch Strahlung polymerisierbares Gemisch nach Anspruch 1, dadurch gekennzeichnet, daß es
10 bis 35 Gew.-% polymerisierbare Verbindung (a),
15 bis 50 Gew.-% polymeres Bindemittel (b),
20 bis 50 Gew.-% Pigment (c),
0,01 bis 10 Gew.-% Polymerisationsinitiator (d),
10 bis 30 Gew.-% vernetzbare Verbindung (e) und
0 bis 1,5 Gew.-% Vernetzungsinitiator (f)
enthält.

8. Verfahren zur Herstellung einer Lötstoppmaske, dadurch gekennzeichnet, daß man eine Lösung bzw. Dispersion eines Gemischs der vorstehend angegebenen Zusammensetzung auf die Oberfläche einer gedruckten Schaltung aufbringt und trocknet, die erhaltene Schicht bildmäßig mit aktinischer Strahlung unter Aussparung der Lötaugen bestrahlt, die unbestrahlten Schichtbereiche mit einem Entwickler auswäscht und die erhaltene Maske auf erhöhte Temperatur erwärmt.